Europäisches Patentamt

European Patent Office

Office européen des brevets

(19)

(11) **EP 1 189 068 A2**

(12) **DEMANDE DE BREVET EUROPEEN**

(43) Date de publication:
**20.03.2002 Bulletin 2002/12**

(51) Int Cl.$^7$: **G01R 31/28**

(21) Numéro de dépôt: **01401851.9**

(22) Date de dépôt: **10.07.2001**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **28.07.2000 FR 0010016**

(71) Demandeur: **Bealach no bo Finne Teo/Ta Galaxy Galway, Irlande (IE)**

(72) Inventeur: **Lejeune, Philippe**
**28630 Sours (FR)**

(74) Mandataire: **Schmit, Christian Norbert Marie**
**Cabinet Christian Schmit et Associés,**
**8, place du Ponceau**
**95000 Cergy (FR)**

(54) **Procédé de teste de composants électroniques tenant compte de la dérive de la moyenne**

(57) Procédé de tests de composants électroniques proposant une optimisation d'une durée des test de ce procédé, cette optimisation consistant à choisir une date de mesure (Dm) la plus précoce possible par rapport à une date initiale (Di) de test. Ce procédé prévoit de choisir cette date de mesure la plus précoce possible en considérant des images statistiques (IS) obtenues sur une population de composants (P1, P2), et en comparant ces images statistiques entre elles au moyen d'un critère. Ce critère tient compte d'une moyenne ($M_0$, $M_{i-TEST}$), et d'une amplitude ($R_0$, $R_{i-TEST}$) des réponses (Vs) fournies par la population de test au cours d'itérations d'un même test avec différentes dates de mesure.

Fig. 2

EP 1 189 068 A2

## Description

La présente invention a pour objet un procédé de tests de composants électroniques tenant compte de la dérive de la moyenne. Elle trouve plus particulièrement son utilisation dans le domaine des tests de composants électroniques semi-conducteurs, notamment des composants tels que des circuits intégrés. Dans l'état de la technique, on connaît un procédé de test de composants électroniques qui permet une réduction du temps de test unitaire pour chacun des composants. L'intérêt de l'invention est qu'elle propose un procédé de test permettant d'une part de réduire le temps de test unitaire et d'autre part de surveiller des dérives des réponses de ces tests dues par exemple à une modification encore tolérable mais éventuellement inquiétante des composants testés.

Un composant à tester est donc soumis à une série de tests unitaires pour tester chacune de ses fonctions. Un test unitaire d'une fonction comporte généralement les étapes élémentaires suivantes :

- à une date initiale $D_0$, on soumet à une borne du composant, cette borne étant considérée comme bornes d'entrée vis-à-vis du test, à un potentiel électrique $V_e$,
- on attend pendant un délai, qu'une réponse apparaisse et se stabilise à une deuxième borne de ce composant, cette deuxième borne étant considérée comme borne de sortie vis-à-vis de ce test,
- à une date de mesure nominale $Dm_0$, à la fin du délai ($Dm_0$ - $D_0$), on mesure cette réponse. Dans un exemple, cette réponse est une valeur $V_s$ d'un potentiel à cette borne de sortie.

Ensuite pour déterminer si le composant a donné une réponse acceptable, ou non acceptable, à ce test unitaire,

- on compare la réponse mesurée à des critères d'acceptation fixés. Soit dans cet exemple, on compare la valeur du potentiel Vs à des limites inférieures et ou supérieures d'acceptation. Ces limites sont généralement fournies par des spécifications de fabrication.

Le composant électronique ayant une structure connue, le délai au bout duquel on peut observer une réponse attendue vis-à-vis du test est déterminé de manière théorique. Ce délai théorique ($Dm_{th}$ - $D_0$) est par exemple calculé par le concepteur du composant électronique. De plus, pour ne pas aboutir à un taux d'échec à ce test trop important, on prend en compte une marge de sécurité en choisissant la date de mesure nominale $Dm_0$, utilisée lors du test. En effet, on choisit généralement la date $Dm_0$ supérieure à la date de mesure théorique $Dm_{th}$ de ce test.

Ensuite, la date de mesure nominale $Dm_0$ est utilisée comme date de mesure pour tous les composants à tester. Ce choix, privilégiant la garantie d'une réponse conforme au test, a pour conséquence d'augmenter considérablement la durée globale de réalisation d'une série de tests.

Dans le document WO-A-97/45748, on connaît un procédé de test permettant de réduire la durée de chaque test unitaire d'une série de tests, et comportant à cet effet :

- une première « phase d'apprentissage » réalisée sur une population de composants acceptables. La date de mesure nominale $Dm_0$ est utilisée pour effectuer les tests sur les premiers composants du lot. Seuls les composants ayant donné une réponse conforme sont incorporés la population de composants acceptables de ce lot, cette population constituant la population d'apprentissage. Ensuite, on détermine, dans la mesure du possible, une date de mesure $Dm_i$ plus précoce que la date de mesure nominale $Dm_0$. Les tests effectués avec cette date de mesure $Dm_i$ doivent permettre d'obtenir une réponse encore acceptable vis-à-vis des limites d'acceptation.
- une deuxième « phase d'application » pendant laquelle on teste tous les autres composants du lot en utilisant la date de mesure plus précoce $Dm_i$ préalablement déterminée.

Pour déterminer la date de mesure $Dm_i$ la plus précoce, on réitère, sur chacun des composants de la population d'apprentissage, les étapes élémentaires du test définies ci-dessus, en diminuant au cours de chaque itération, soit de manière dichotomique, soit de manière pas-à-pas, la date de mesure appliquée. Pour choisir la date de mesure $Dm_i$ parmi les dates de mesure intermédiaires testées : $Dm_{i-TEST1}$, $Dm_{i-TEST2}$, on compare au moyen d'un critère :

- une image statistique des réponses obtenues avec au moins une date de mesure intermédiaire testée, par exemple $Dm_{i-TEST1}$, à
- une image statistique des réponses de cette même population d'apprentissage, obtenues à la date de mesure nominale $Dm_0$.

Une image statistique comporte l'ensemble des réponses, de type Vs, obtenues au cours du test, et notamment le calcul à partir de ces valeurs, de la moyenne M, et de l'écart type S, et ou de toutes autres valeurs statistiques fonction de cette moyenne M et de cet écart-type S.

Par exemple, on définit pour chaque image statistique, une valeur statistique notée CP égale à un rapport entre une différence de limites d'acceptation et l'écart-type S de cette image statistique. La différence des limites d'acceptation est généralement fournie par une tolérance du fabricant.

Une autre valeur statistique peut également être définie pour caractériser chaque image statistique, cette autre valeur notée CPK est alors égale au rapport entre une valeur absolue d'une différence entre la moyenne et une limite d'acceptation, et l'écart-type S de cette image statistique.

Pour comparer les images statistiques entre elles, on compare leur valeur statistique CP, ou CPK respective. On choisit la date de mesure $Dm_i$ la plus précoce possible, telle qu'une valeur statistique $CP_i$, obtenue avec la date de mesure $Dm_i$, reste dans une certaine proportion du critère d'appréciation $CP_o$, où $CP_o$ est la valeur statistique caractérisant l'image statistique obtenue avec la date de mesure nominale $Dm_0$.

Dans un premier exemple, si pour une date de mesure intermédiaire testée $Dm_{i-TEST1}$, on observe une gamme large de réponses, sans qu'aucune valeur ne prédomine, cela signifie que le comportement du composant électronique à ce test n'est pas reproductible de manière fiable à cette date. Selon le procédé de l'invention l'écart-type $S_{i-TEST1}$ de l'image statistique obtenue pour cette date de mesure est grand, et donc la valeur $CP_{i-TEST1}$ correspondante sera faible, et ne sera certainement plus dans le critère de proportion de $CP_o$ fixé. Alors cette date de mesure $Dm_{i-TEST1}$ ne sera pas retenue comme date de mesure $Dm_i$ la plus précoce possible, et $Dm_i$ sera nécessairement plus grand que cette date testée $Dm_{i-TEST}$.

Le procédé de détermination de la date de mesure $Dm_i$ la plus précoce peut prévoir une autre condition d'acceptation, par exemple que celle ci soit nécessairement supérieure à une date de mesure minimale théorique $Dm_{min}$.

La solution proposée dans ce document WO 97/45748, présente un problème car la phase d'apprentissage préalable à l'exécution de la phase d'application est trop longue. De plus, la date de mesure la plus précoce possible déterminée au cours de cette phase d'apprentissage peut être la cause d'un taux de rejet plus important des composants électroniques testés, car des composants peuvent de ce fait être injustement écartés de la production correcte. En effet la phase d'apprentissage étant longue, elle n'est pas réalisée trop fréquemment, et alors une date de mesure non adaptée peut être utilisée pour tester une partie du lot.

De l'enseignement du document FR 99 09055, on connaît un procédé comportant également une phase d'apprentissage et une phase d'application.

Mais ce procédé prévoit que la phase d'apprentissage qui permet de définir la date de mesure $Dm_i$ la plus précoce possible soit réalisée en faisant la comparaison entre :

- une image statistique des réponses de la population d'apprentissage obtenues avec la date de mesure nominale $Dm_0$, à
- une image statistique cumulée, cette image correspondant à l'image de l'ensemble des réponses obtenues sur cette même population à la fois avec la date de mesure intermédiaire testée, par exemple $Dm_{i-TEST1}$, et à la fois avec les réponses obtenues sur cette population à la date de mesure nominale $Dm_0$.

Pour comparer les images statistiques entre elles, on compare de la même manière leur valeur statistique CPK respective. On choisit la date de mesure $Dm_i$ la plus précoce possible, telle que la valeur statistique $CPK_{cumul\,:0+i-TEST1}$, reste dans une certaine proportion du critère d'appréciation $Cpk_o$, où $Cpk_o$ est la valeur statistique caractérisant l'image statistique obtenue avec la date de mesure nominale $Dm_0$.

De plus, ce procédé prévoit que la phase d'application soit indépendante de la phase d'apprentissage qui est réalisée sur une population d'apprentissage indépendante des composants du lot à tester pendant la phase d'application. Ainsi la phase d'apprentissage est réalisée indépendamment, et seule une phase d'ajustage courte est réalisée au démarrage d'une série de tests à effectuer pour un lot de composants. Au cours de cette phase d'ajustage, la date de mesure Dmi la plus précoce définie est validée, et éventuellement ajustée.

Ces phases d'ajustage sont régulières, par exemple selon une certaine fréquence fonction du nombre donné de pièces du lot testées, et permettent que la date de mesure soit toujours optimisée vis-à-vis de la durée des tests, et optimisée vis à vis de la rentabilité de cette production testée, en tenant compte de la variabilité naturelle des caractéristiques de la production.

Pendant cette phase d'ajustage, on considère une population de composants corrects. Et, de même que pendant la phase d'apprentissage, la date de mesure $Dm_i$ la plus précoce est vérifiée et éventuellement modifiée en comparant :

- une image statistique des réponses de la population de composants corrects obtenues avec la date de mesure nominale $Dm_0$, à
- une image statistique cumulée, cette image correspondant à l'image de l'ensemble des réponses obtenues sur cette même population à la fois avec la date de mesure $Dm_i$, ou avec une date de mesure modifiée $Dm_{modif}$ et à la fois avec les réponses obtenues sur cette population à la date de mesure nominale $Dm_0$.

Eventuellement on choisit d'appliquer une date de mesure modifiée $Dm_{modif}$, $Dm_{modif}$ étant supérieure ou égale à la date de mesure $Dm_i$, si la comparaison de l'image statistique cumulée, comportant entre autres les réponses obtenues à la date de mesure $Dm_i$, avec l'image statistique de cette même population obtenue avec la date de mesure nominale $Dm_0$ n'est pas acceptable vis-à-vis d'un critère d'appréciation.

Cette solution pose également un problème. En effet, même si ce procédé comporte une phase d'ajustage pour prendre en compte la variabilité intrinsèque de la production de composants, ce procédé tolère et ne relève pas la présence de dérives au sein de cette production. Selon ce procédé de test, la variabilité des réponses et leur dérive éventuelle n'est pas considérée, car les images statistiques représentant ces données sont comparées par l'intermédiaire d'une valeur statistique : CPK. Or cette valeur statistique CPK est calculée en incorporant des limites inférieures et ou des limites supérieures d'acceptation, ces limites n'étant pas déterminées en fonction de la méthode de fabrication des composants, mais établies en fonction de limites tolérables vis-à-vis de la qualité des composants fabriqués : du cahier des charges de ces composants.

Ce procédé conduit donc à déterminer des valeurs statistiques CPK de l'ordre du millier, lorsqu'il s'agit de valeurs de réponse d'une image statistique obtenues pour une date de mesure proche de la date de mesure nominale $Dm_0$. Mais comme le critère d'appréciation de cette valeur statistique est une comparaison avec un critère d'acceptation de l'ordre de 3, le mode de détermination de la date de mesure $Dm_i$ la plus précoce possible conduit à choisir une date de mesure $Dm_i$ très proche de la date de mesure minimale $Dm_{min}$. Par conséquent le test va accepter avec cette formule des composants ayant donné une réponse très proche de l'une des limites d'acceptation, ce qui peut pourtant être un signe d'une dérive de la fabrication de ces composants à détecter.

Et même si la phase d'ajustage permet de corriger le choix d'une date de mesure $Dm_i$ trop faible, la phase d'ajustage devient alors quasiment aussi longue que la phase d'apprentissage, ce qui constitue également un inconvénient. En effet, ce procédé de test conduit à devoir quasiment systématiquement procéder à une augmentation de cette date de mesure $Dm_i$ lors de la phase d'ajustage, car la date définie lors de la phase d'apprentissage est inadaptée à la production à tester.

L'invention a pour objet de résoudre ce problème en détectant plus rapidement les signes de dérive de la fabrication des composants. L'invention permet notamment de limiter la recherche de la date de mesure $Dm_i$ la plus précoce à la détermination d'une date de mesure pour laquelle la dérive de la moyenne est contrôlée. Donc la date de mesure $Dm_i$ la plus précoce possible déterminée selon le procédé de l'invention permet de garantir l'obtention de réponses au test qui soient sûres. Néanmoins, la date de mesure $Dm_i$ la plus précoce, déterminée selon ce procédé, peut être plus élevée que celle qui aurait été obtenue en utilisant un autre procédé de test recherchant également à diminuer la durée globale du temps de test.

En effet, l'invention a pour objet un procédé de test de composants électroniques dans lequel on considère des images statistiques de population de composants, en les représentant par des valeurs statistiques qui ne tiennent pas compte, en premier lieu, de ces limites d'acceptation. De plus, le procédé selon l'invention compare les images statistiques entre elles, en considérant des valeurs statistiques comportant au moins un critère d'acceptation indépendant des limites d'acceptation. La comparaison ainsi effectuée est beaucoup plus sévère et tolère moins de variabilité des réponses au test. La date de mesure plus précoce définie selon ce procédé garantit une plus grande fiabilité, et diminue la nécessité de la corriger trop fréquemment.

L'invention a pour objet un procédé de test de composants électroniques dans lequel

- on soumet à une date initiale une borne d'un composant à un potentiel électrique,
- on mesure, à une date de mesure, une réponse établie à une borne de ce composant,
- on compare cette réponse à des limites d'acceptation, pour accepter ou rejeter le composant en fonction de cette comparaison,
- la date de mesure est définie au moyen d'un critère appliqué pour comparer une image statistique intermédiaire représentant au moins des réponses obtenues à une date de mesure intermédiaire testée, avec une image statistique nominale représentant des réponses obtenues à une date de mesure nominale, les réponses étant obtenues à partir d'une population de composants corrects
- on retient comme date de mesure une date de mesure intermédiaire testée la plus précoce possible,

    caractérisé en ce que

- le critère appliqué pour comparer les images statistiques entre elles comporte une évaluation d'une amplitude des réponses obtenues pour chacune des images statistiques.

L'invention sera mieux comprise à la lecture de la description qui suit et à l'examen des figures qui l'accompagnent. Celles-ci ne sont présentées qu'à titre indicatif et nullement limitatif de l'invention. Les figures montrent :

- Figure 1 : une représentation d'une population de composants à tester selon le procédé selon l'invention ;
- Figure 2 : une représentation de la répartition des réponses de la population de composants corrects obtenues avec le procédé de test selon l'invention à différentes dates de mesure ;
- Figure 3 : une table de paramètres ;
- Figure 4 : un diagramme chronologique représentant l'agencement dans le temps de la phase d'apprentissage, des phases d'ajustage et des phases d'application selon l'invention.

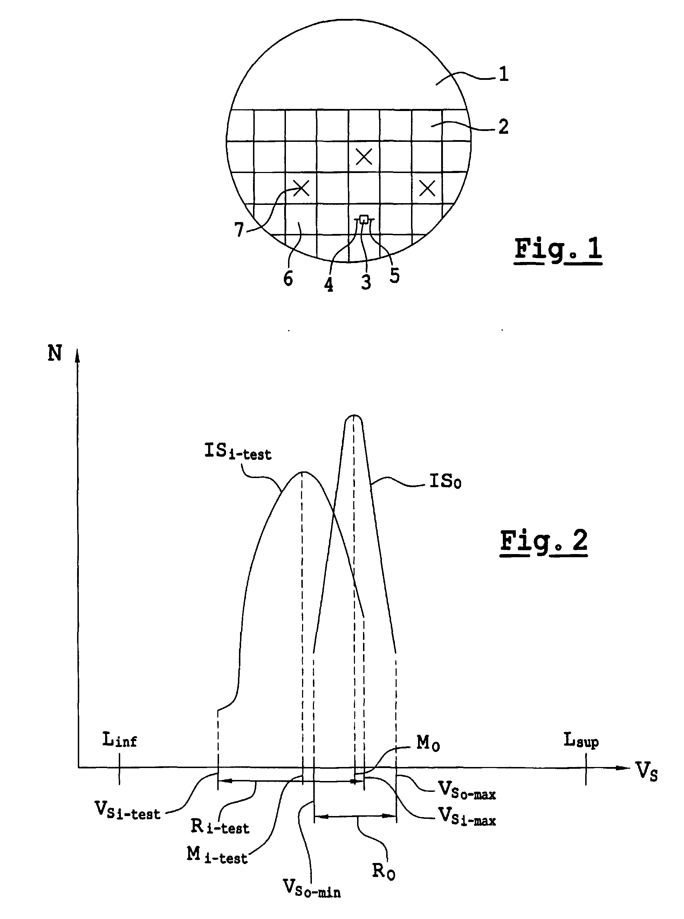

La figure 1 présente une plaquette 1 supportant des composants électroniques 2. La plaquette 1 peut également être appelée gaufrette ou "wafer". Cette plaquette peut avoir une forme circulaire ou bien une forme parallélépipèdique dite en réglette. Les composants électroniques 2 de la plaquette 1 sont par exemple des puces de circuits intégrés. Un composant électronique 2 comporte au moins une fonction 3 à tester.

Pour tester la fonction 3 du composant électronique 2, on utilise un appareil de test comportant un premier jeu d'électrodes venant appliquer le potentiel $V_e$ à une borne d'entrée 4, et un deuxième jeu d'électrodes venant capter un potentiel de sortie $V_s$ à une borne de sortie 5. Une interface de l'appareil de test permet de gérer l'émission de signaux électriques et la mesure de signaux captés. L'interface est configurée par des moyens de test de l'appareil de test. La configuration de l'interface permet de traiter les signaux envoyés et reçus par elles.

Les bornes 4 et 5 sont des bornes conductrices du composant 2. La borne de sortie 5 peut éventuellement confondue avec la borne d'entrée 4 sur ce composant.

Une réponse à ce test est généralement constituée par une grandeur électrique mesurée, par exemple la valeur du potentiel de sortie $V_s$. Et l'interface permet, au vu de cette réponse de décider si un composant est bon ou mauvais vis-à-vis du test réalisé. L'interface prévoit notamment de comparer cette réponse $V_s$ à des limites d'acceptation fixées par le fabricant de ces composants.

Pour effectuer le test, la réponse $V_s$ est mesurée à une date de mesure Dm, cette date de mesure étant nécessairement postérieure à une date initiale $D_0$ à laquelle le potentiel $V_e$ a été émis aux bornes d'entrée 4.

Pour améliorer le délai entre Dm et $D_0$, soit généralement en le diminuant, on commence par déterminer une population de composants corrects P1 sur la plaquette 1. A cette fin, on teste des composants électroniques 2 avec une date de mesure égale à une date de mesure nominale $Dm_0$. Cette date de mesure $Dm_0$ a préférentiellement été déterminé de manière théorique en tenant compte d'une marge de sécurité en plus. Généralement cette date de mesure correspond à la date de mesure utilisée par un procédé de test classique, non optimisé. Ainsi, on identifie des composants acceptables 6 et des composants non acceptables 7 sur la plaquette 1. Dans un exemple préféré, la population de composants corrects P1 comporte un seul composant acceptable 6, néanmoins elle peut comporter plusieurs composants tels que 6.

Ensuite, on détermine une image statistique IS de cette population P1. L'image statistique IS comporte un ensemble de N réponses obtenues à partir de la population P1 en réitérant le même test, avec la même date de mesure. On définit alors une image statistique IS correspondant à une date de mesure donnée.

La figure 2 donne une représentation de l'image statistique nominale $IS_0$, comportant un ensemble de réponses $V_{s0}$ de la population P1 obtenues suite à $N_0$ itérations du test effectué avec la date de mesure nominale $Dm_0$. Une répartition de ces réponses est généralement gaussienne. L'image $IS_0$ peut être caractérisée par la valeur d'une moyenne $M_0$ et ou d'une amplitude $R_0$.

La moyenne $M_0$ correspond à la moyenne de l'ensemble des réponses $V_{s0}$ observées pour les itérations faites avec la même date de mesure nominale $Dm_0$.

$$M_0 = \text{somme } (V_{s0}) / N_0$$

Et l'amplitude $R_0$ correspond à la différence entre la plus grande valeur de réponse $V_{s0\text{-}max}$ observée et la plus petite valeur de réponse $V_{s0\text{-}min}$ observée, au cours de ces mêmes itérations.

$$R_0 = V_{s0\text{-}max} - V_{s0\text{-}min}$$

Ensuite, pour tester des dates de mesure plus précoces, on réitère le même test sur la même population P1 avec des dates de mesures différentes. Par exemple, on effectue un nombre $N_{i\text{-}TEST}$ d'itérations de ce test avec une date de mesure intermédiaire testée $Dm_{i\text{-}TEST}$. Ainsi, on obtient une image statistique $IS_{i\text{-}TEST}$, $IS_{i\text{-}TEST}$ pouvant être caractérisée par une moyenne $M_{i\text{-}TEST}$ et ou une amplitude $R_{i\text{-}TEST}$.

Dans ce cas, on définit la moyenne $M_{i\text{-}TEST}$ comme étant la moyenne de l'ensemble des réponses $V_{si}$ observées pour les itérations faites avec la même date de mesure $Dm_{i\text{-}TEST}$.

$$M_{i\text{-}TEST} = \text{somme } (V_{si}) / N_{i\text{-}TEST}$$

Et l'amplitude $R_{i\text{-}TEST}$ correspond à la différence entre la plus grande valeur de réponse $V_{sl\text{-}max}$ observée et la plus petite valeur de réponse observée $V_{sl\text{-}min}$, au cours de ces mêmes itérations.

$$R_{i\text{-}TEST} = V_{sl\text{-}max} - V_{sl\text{-}min}$$

Ensuite, pour déterminer si la date de mesure intermédiaire testée $Dm_{i\text{-}TEST}$ peut être acceptée comme date de mesure plus précoce pour être utilisée pendant une phase d'application du procédé selon l'invention, on compare les images statistiques $IS_0$ et $IS_{i\text{-}TEST}$ entre elles au moyen d'un critère.

Par exemple, on accepte cette date de mesure $Dm_{i\text{-}TEST}$, si la moyenne $M_{i\text{-}TEST}$ est également comprise dans un intervalle d'acceptation. Dans un exemple préféré de l'invention, si la moyenne $M_{i\text{-}TEST}$ répond à la condition suivante:

$$|M_{i\text{-}TEST} - M_0| < D - Z * S_0 * \sqrt{(1/ N_{i\text{-}TEST} + 1/ N_0)}$$

où le terme mathématique entre barres verticales correspond à une valeur absolue.

$S_0$ est l'écart type des réponses $V_{s0}$ obtenues à la suite des $N_0$ itérations, et est défini préférentiellement par la formule suivante:

$$S_0{}^2 = 1/(N_0 - 1) * [\text{somme (i= 1 à } N_0) \text{ des } (M_0 - V_{s0}^i)^2].$$

Par ailleurs, D correspond à un écart toléré entre les deux moyennes $M_{i\text{-}TEST}$ et $M_0$. D est généralement fixé par un ingénieur responsable du réglage de l'appareil de test en fonction des spécifications du composant testé.

Le paramètre z correspond à une constante qui est choisie à partir de tables statistiques, en fonction d'un niveau de risque choisi vis-à-vis des tests réalisés. Le niveau de risque est défini en considération d'un premier risque $\alpha$ correspondant à un risque dit de "fausse alarme", et d'un deuxième risque $\beta$ correspondant à un risque dit du "signal manqué". Le risque $\alpha$ correspond à une probabilité de rejeter un composant à l'issue d'un test alors que le composant est bon. Le risque $\beta$ correspond à une probabilité d'accepter un composant à l'issue d'un test alors que celui ci est mauvais. Le paramètre z est choisi de manière à ce que le risque $\beta$ soit minimal, par exemple égal à 0,05. Dans ce cas, le paramètre z vaut alors 1,645.

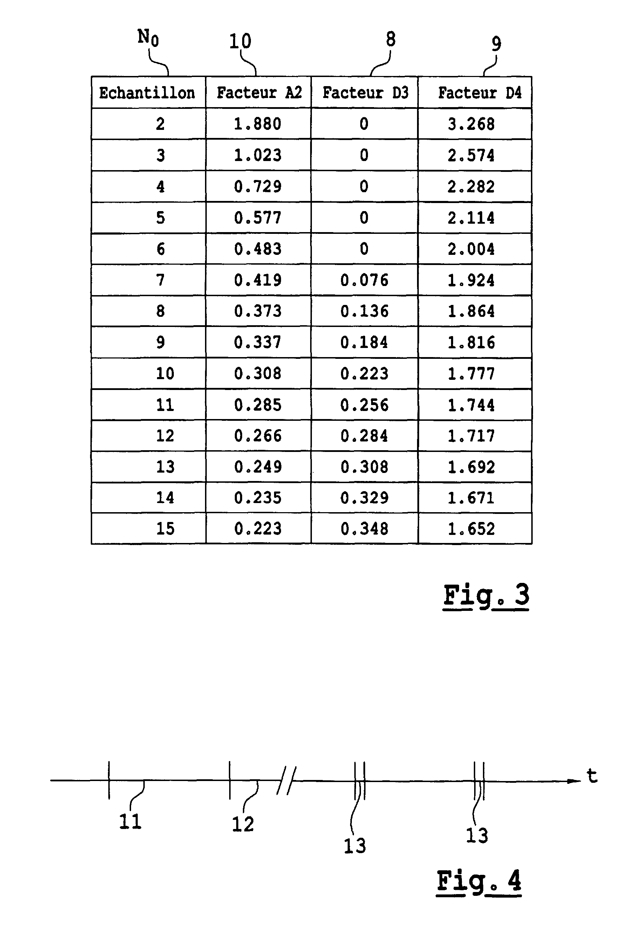

Dans une première variante du test de la moyenne, on utilise des paramètres de la table présentée Figure 3, pour déterminer une borne inférieure d'acceptation $BM_{inf}$ et une borne supérieure d'acceptation $BM_{sup}$ de cet intervalle d'acceptation de la moyenne. Par exemple, les paramètres A2 proposés dans la colonne 10 permettent de calculer ces bornes. Cet intervalle est défini en fonction de la moyenne nominale $M_0$ et de l'amplitude nominale $R_0$.

$$BM_{inf} = M_0 - A2 * R_0,$$

$$BM_{sup} = M_0 + A2 * R_0,$$

Dans une deuxième variante du test de la moyenne, notamment dans le cas où l'amplitude nominale serait très faible, cet intervalle peut être défini différemment. En particulier, cet intervalle peut être déterminé en fonction des limites inférieure Linf et supérieure Lsup déterminées pour évaluer les réponses $V_s$. Alors les bornes inférieures et supérieures d'acceptation peuvent être définie comme suit :

$$BM_{inf} = M_0 - A2 * f1 * (Lsup - Linf),$$

$$BM_{sup} = M_0 + A2 * f1 * (Lsup - Linf),$$

Où f1 correspond à une valeur réelle par exemple comprise entre 0 et 1.

Dans une troisième variante du test de la moyenne, notamment dans le cas où les réponses $V_s$ ne doivent remplir qu'une seule condition, vis-à-vis d'une seule limite L, l'intervalle peut être défini comme suit :

$$BM_{inf} = M_0 - A2 * f1 * | L - M_0 |,$$

$$BM_{sup} = M_0 + A2 * f1 * | L - M_0 |,$$

Les paramètres A2 utilisés dans les formules ci-dessus sont choisis en fonction du nombre d'itérations $N_{TEST}$ effectuées pour déterminer $M_{i\text{-}TEST}$. En effet, plus $N_{TEST}$ sera grand, plus la moyenne déterminée sera fiable et devra donc se situer dans un intervalle très serré autour de la moyenne nominale $M_0$.

De plus, on peut décider d'accepter cette date de mesure $Dm_{i\text{-}TEST}$, si une deuxième condition est remplie vis-à-vis de l'amplitude $R_{i\text{-}TEST}$. Dans un exemple préféré, $Dm_{i\text{-}TEST}$ est retenue si, pour une même date intermédiaire testée, acceptée vis-à-vis du test sur la moyenne $M_{i\text{-}TEST}$, l'amplitude $R_{i\text{-}TEST}$ correspondante répond à la condition suivante:

la valeur absolue de la différence entre $R_{i\text{-}TEST}$ et $R_0$ est inférieure à un seuil fixé par cet ingénieur responsable du réglage de l'appareil en fonction des spécifications du composant testé.

Dans une variante de ce test sur l'amplitude, on peut utiliser des paramètres de la table présentée Figure 3, pour déterminer une borne inférieure d'acceptation $BR_{inf}$ et une borne supérieure d'acceptation $BR_{sup}$ de cet intervalle d'acceptation. Par exemple, les paramètres proposés dans les colonnes 8 et 9 permettent de calculer ces bornes. Cet intervalle est alors défini en fonction de l'amplitude nominale $R_0$.

$BR_{inf} = D3 * R_0$, où D3 est un paramètre de la colonne 8.
$BR_{sup} = D4 * R_0$, où D4 est un paramètre de la colonne 9.

Dans une deuxième variante de ce test sur l'amplitude, cet intervalle est défini en fonction de limites inférieure Linf et supérieure Lsup déterminées, généralement par le concepteur du test, pour évaluer les réponses $V_s$. Cette variante permet d'éviter de déterminer un intervalle d'acceptation trop serré du seul fait que l'amplitude nominale R0 est très petite, comme ça peut être le cas en appliquant la méthode prévue par la première variante, alors que l'intervalle d'acceptation réel est beaucoup plus large. Alors les bornes inférieures et supérieures d'acceptation peuvent être définie comme suit :

$$BR_{inf} = D3 * f1 * (Lsup - Linf),$$

$$BR_{sup} = D4 * f1 * (Lsup - Linf),$$

Où f1 correspond à une valeur réelle par exemple comprise entre 0 et 1. Dans cette deuxième variante, l'intervalle d'acceptation est fonction d'un pourcentage de l'intervalle d'acceptation réel.

Dans une troisième variante du test sur l'amplitude, l'intervalle peut être défini en fonction des limites Linf et Lsup, et de la moyenne $M_0$, notamment dans le cas où les réponses $V_s$ ne doivent remplir qu'une seule condition, vis-à-vis d'une seule limite L. Alors les bornes inférieures et supérieures d'acceptation peuvent être définie comme suit :

$$BR_{inf} = D3 * f1 * | L - M_0 |,$$

$$BR_{sup} = D4 * f1 * | L - M_0 |,$$

Où les éléments définis entre deux barres verticales correspondent à une valeur absolue de ces mêmes éléments.

Les paramètres D3 et D4 utilisés dans chacune des formules ci-dessus sont choisis en fonction du nombre d'itérations $N_{TEST}$ effectuées pour déterminer $R_{i-TEST}$. En effet, plus $N_{TEST}$ sera grand, plus la borne supérieure $BR_{sup}$ de l'intervalle d'appréciation de l'amplitude se rapprochera de l'amplitude nominale $R_0$. Parallèlement, plus $N_{TEST}$ sera grand, plus la borne inférieure $BR_{inf}$ pourra s'éloigner de l'amplitude nominale $R_0$. En effet, il est probable qu'étant donné que l'on teste une date de mesure antérieure à la date de mesure nominale, la répartition des réponses Vs ainsi obtenues soit moins précise.

Si une date de mesure intermédiaire $Dm_{i-TEST}$ est retenue suite à cette comparaison, généralement on teste de la même manière une deuxième date de mesure intermédiaire plus précoce. Et on retient ensuite pour appliquer lors de la phase d'application, la date de mesure la plus précoce possible. Par contre, si cette date de mesure intermédiaire n'est pas validée suite à cette comparaison, on teste une autre date de mesure intermédiaire, cette autre date devant être la plus précoce possible et encore antérieure à la date de mesure nominale. Généralement on teste des dates de mesure intermédiaires selon une méthode pas-à-pas pour retenir comme date de mesure la dernière date qui a été validée avant que l'on teste une date qui ne soit pas validée.

Selon un mode particulier d'utilisation du procédé de test, on détermine la date de mesure la plus précoce possible au cours d'une première phase 11, Figure 4, appelée phase d'apprentissage. Ensuite cette date de mesure déterminée est appliquée continûment au cours de la phase d'application 12.

Dans une variante, on peut prévoir de manière régulière des phases d'ajustage 13 au cours de la phase d'application 12, pour valider la date de mesure déterminée au cours de la phase d'apprentissage, et éventuellement déterminer une date de mesure ajustée Dma.

Pour valider la date de mesure intermédiaire au cours d'une phase d'ajustage, on considère une population P2 de composants, ces composants étant corrects lorsqu'ils sont testés avec la date de mesure nominale $D_0$. Les composants de la population P2 sont préférentiellement issus d'un lot testé au cours de la phase d'application. Et ensuite on compare des images statistiques obtenues à partir d'itérations du même test sur cette population P2.

Généralement on effectue la démarche de détermination d'une date de mesure ajustée Dma si seulement la date de mesure intermédiaire la plus précoce n'est pas validée. Cette date de mesure ajustée Dma est alors postérieure à la date de mesure intermédiaire la plus précoce déterminée au cours de la phase d'apprentissage.

Une date de mesure ajustée Dma, pour être retenue, doit répondre aux mêmes conditions de comparaison que celles énoncées ci-dessus pour la détermination de la date de mesure intermédiaire la plus précoce. La considération de la moyenne et de l'amplitude des résultats de la population P2 servant à l'ajustage est évaluée de la même manière.

Dans un premier exemple préféré, au cours de la phase d'apprentissage, l'image statistique nominale $IS_0$ est déterminée en considérant 10 valeurs obtenues suite à l'itérations du même test avec la date de mesure nominale $D_0$. Préférentiellement, ces 10 valeurs sont obtenues par 10 itérations du même test sur l'unique composant constituant la population P1. Au cours de cette même phase, la date de mesure intermédiaire la plus précoce possible est déterminée en considérant 5 valeurs obtenues par itérations du test avec cette date de mesure. Préférentiellement, ces 5 valeurs sont obtenues par 5 itérations du test sur le composant unique de la population P1.

Dans un deuxième exemple préféré, au cours des phases d'ajustage, on détermine l'image statistique nominale de la population P2 en considérant 3 valeurs obtenues avec cette date de mesure nominale $D_0$, ces 3 valeurs étant préférentiellement obtenues suite à 3 itérations du même test sur un même composant de P2. La date de mesure la plus précoce déterminée au cours de la phase d'apprentissage est validée, ou une date de mesure Dma est déterminée, en considérant des images statistiques obtenues pour chacune de ces dates, à partir de 2 valeurs. Les 2 valeurs étant préférentiellement obtenues à partir de 2 itérations du même test sur le même composant de la population P2.

Le procédé de test selon l'invention est appliqué notamment pour optimiser les temps de test de tous les tests pour lesquels une dérive de la moyenne n'est pas tolérable.

Dans une autre variante, on peut prévoir que l'optimisation du temps de test est effectuée en considérant une image statistique comportant à la fois les réponses $V_s$ et d'autre part des données déterminées en fonction de ces réponses $V_s$, ces données pouvant tenir compte d'une dérive tolérée des valeurs $V_s$.

## Revendications

1.  Procédé de test de composants électroniques dans lequel

    - on soumet à une date initiale ($D_0$) une borne (4) d'un composant (2) à un potentiel électrique ($V_e$),
    - on mesure, à une date de mesure (Dm), une réponse (Vs) établie à une borne (5) de ce composant,
    - on compare cette réponse à des limites d'acceptation, pour accepter ou rejeter le composant en fonction de cette comparaison,
    - la date de mesure est définie au moyen d'un critère appliqué pour comparer une image statistique intermédiaire ($IS_{i-TEST}$) représentant au moins des réponses obtenues à une date de mesure intermédiaire testée ($Dm_{i-TEST}$), avec une image statistique nominale ($IS_0$) représentant des réponses obtenues à une date de mesure nominale ($Dm_0$), les réponses étant obtenues à partir d'une population (P1) de composants corrects
    - on retient comme date de mesure une date de mesure intermédiaire testée la plus précoce possible,

        **caractérisé en ce que**

    - le critère appliqué pour comparer les images statistiques entre elles comporte une évaluation d'une amplitude ($R_0$, $R_{i-TEST}$) des réponses obtenues pour chacune des images statistiques.

2.  Procédé selon la revendication 1 **caractérisé en ce que**

    - on détermine un intervalle d'acceptation ($BR_{inf}$, $BR_{sup}$) de l'amplitude ($R_{i-TEST}$) correspondant à une date de mesure testée en fonction d'une amplitude nominale ($R_0$), et ou en fonction d'une amplitude tolérée.

3.  Procédé selon l'une des revendications 1 à 2 **caractérisé en ce que**

    - le critère appliqué pour comparer les images statistiques entre elles comporte une évaluation d'une moyenne ($M_0$, $M_{i-TEST}$) des réponses obtenues pour chacune des images statistiques.

4.  Procédé selon la revendication 3 **caractérisé en ce que**

    - on détermine un intervalle d'acceptation ($BM_{inf}$, $BM_{sup}$) de la moyenne ($M_{i-TEST}$) correspondant à la date de mesure testée en fonction de la moyenne nominale ($M_0$).

5.  Procédé selon l'une des revendications 3 à 4 **caractérisé en ce que**

    - on détermine l'intervalle d'acceptation de la moyenne correspondant à la date de mesure testée en fonction d'un écart type nominal ($S_0$) des réponses obtenues à la date de mesure nominale, et en fonction d'une probabilité statistique ($\alpha$, $\beta$).

6.  Procédé selon l'une des revendications 3 à 5 **caractérisé en ce que**

    - on détermine l'intervalle d'acceptation de la moyenne correspondant à la date de mesure testée en fonction de l'amplitude nominale, et ou en fonction d'une amplitude tolérée.
    - on détermine les intervalles d'acceptation en fonctions de paramètres (A2, D3, D4) issus d'une table, ces paramètres tenant compte du nombres (N) de valeurs des images statistiques.

7.  Procédé selon l'une des revendications 1 à 6 **caractérisé en ce que**

    - on considère une population de composants corrects comportant un unique composant.

8.  procédé selon l'une des revendications 1 à 7 **caractérisé en ce que**

    - on détermine la date de mesure au cours d'une phase d'apprentissage (11) préalable à une phase d'application (12) du procédé de test.

9.  Procédé selon la revendication 8 **caractérisé en ce que**

- on effectue des itérations du test sur la population de composants corrects avec la date de mesure nominale, par exemple pour obtenir 10 valeurs,
- on effectue des itérations du test sur cette même population avec une date de mesure intermédiaire, par exemple pour obtenir 5 valeurs.

10. Procédé selon l'une des revendications 1 à 9 **caractérisé en ce que**

- on modifie la date de mesure pendant une phase d'application, au cours d'une phase d'ajustage (13).
- on effectue des itérations du test sur une population de composants corrects (P2) issue de la phase d'application avec la date de mesure nominale, par exemple pour obtenir 3 valeurs,
- on effectue des itérations du test sur cette même population avec une date de mesure intermédiaire, par exemple pour obtenir 2 valeurs.

Fig. 1

Fig. 2

| Echantillon | Facteur A2 | Facteur D3 | Facteur D4 |
|:-----------:|:----------:|:----------:|:----------:|
| 2 | 1.880 | 0 | 3.268 |
| 3 | 1.023 | 0 | 2.574 |
| 4 | 0.729 | 0 | 2.282 |
| 5 | 0.577 | 0 | 2.114 |
| 6 | 0.483 | 0 | 2.004 |
| 7 | 0.419 | 0.076 | 1.924 |
| 8 | 0.373 | 0.136 | 1.864 |
| 9 | 0.337 | 0.184 | 1.816 |
| 10 | 0.308 | 0.223 | 1.777 |
| 11 | 0.285 | 0.256 | 1.744 |
| 12 | 0.266 | 0.284 | 1.717 |
| 13 | 0.249 | 0.308 | 1.692 |
| 14 | 0.235 | 0.329 | 1.671 |
| 15 | 0.223 | 0.348 | 1.652 |

**Fig. 3**

**Fig. 4**